# EUROPEAN PATENT SPECIFICATION

(11) **EP 2 679 023 B1**
(45) Date of publication and mention of the grant of the patent: **02.01.2019**
(21) Application number: 11859338.3
(22) Date of filing: 25.02.2011
(51) Int. Cl.: H04R 7/26, H04M 1/03, H04R 1/22, H04R 3/00, H04R 7/08, H04R 1/08, H04R 7/04, H04R 19/00, H04R 1/28

(54) **A TRANSDUCER APPARATUS**
WANDLERVORRICHTUNG
APPAREIL TRANSDUCTEUR

(43) Date of publication of application: 01.01.2014
(73) Proprietor: Nokia Technologies Oy, 02610 Espoo (FI)
(72) Inventor: SUVANTO, Mikko, Veli, Aimo, 36200 Kankasala (FI); REHDER, Jorg, 02150 Espoo (FI)
(74) Representative: Berggren Oy, Helsinki & Oulu
(86) International application number: PCT/IB2011/050817
(87) International publication number: WO 2012/114159

(56) References cited:
- EP-A1- 0 081 780
- EP-A1- 2 242 288
- WO-A1-2011/001012
- US-A1- 2002 094 101
- US-A1- 2007 007 858

## Description

### Field of the Application

The present invention relates to a transducer apparatus. The invention further relates to, but is not limited to, a transducer apparatus for use in mobile devices.

### Background of the Application

Many portable devices, for example mobile telephones, contain a number of acoustic transducers, such as microphones, earpieces and speakers. Such transducers are key components in mobile phone audio/acoustic design. Generally, there will be one or more sound channels or back cavities associated with each acoustic transducer. Such sound channels can ensure a certain frequency response is obtained for the transducer, and must be carefully designed as part of the mechanical configuration of the device hardware. Small changes in the size and configuration of the sound channels or cavities can have a large effect on the acoustic properties of the combined transducer/sound channel.

In known acoustic transducer configurations, the mechanical design of the sound channels is fixed at the point of hardware design and manufacture of the device is completed, and cannot be later adapted during use for a specific purpose or desired configuration. Instead, the desired acoustic properties are produced by filtering the electrical signal representing the sound output before the signal is applied to the transducer. Typically, this requires the use of significant processing power, commonly provided by dedicated digital signal processors (DSPs).

Furthermore there is a limit to the modification of the acoustic response of the transducer which can be carried out in the DSP.

An example of the limitations of the mechanical design of typical microphone transducers is that of wind noise. Wind noise is a problem particularly for miniaturised designs such as found in mobile phone where there is no room for mechanical protection of the microphone from wind such as used in broadcast microphones like wind screens or foam protectors. Furthermore filtering out the wind noise from the signal in the electrical domain, not only requires significant processing power in a digital signal processor, but typically produces poor results as the sound pressure levels generated by the wind cause the microphone acoustic element to saturate.

In related art, US 2007/007858 A1 discloses a microphone with a membrane. The membrane has a first side which is in fluid contact with the surroundings and a second side which is facing a back chamber, where a barometric relief opening or vent opening is provided between the back chamber and the surroundings. According to the invention control means are provided for controlling the barometric relief opening.

EP 2242288 A1 discloses a microphone that comprises a movable diaphragm and a back electrode. The mechanical relationship between the back electrode and the diaphragm is adjustable thereby to control the cut-off frequency of the microphone. This enables the microphone to be adapted to different noise environments.

WO 2011/001012 A1 discloses an apparatus comprising: an acoustic transducer, and a sound channel coupled to the acoustic transducer, the sound channel comprising an element having a shape that is electrically controllable, wherein the shape of the element is electrically controllable to change the acoustic properties of the sound channel.

### Statement of the Application

This application proceeds from the consideration that the provision of an adjustable acoustic overpass filter may provide suitable wind noise reduction in audio capture environments.

It is an aim of at least some embodiments of the invention to address one or more of these problems.

According to a first aspect there is provided a micro-electromechanical system, MEMS, microphone transducer comprising: a membrane and a back plate configured to define a volume of air therebetween and a mechanical acoustic filter configured to be electrically controllable to change the acoustic properties of the transducer, wherein the mechanical acoustic filter comprises at least one filter hole and, within said volume or air, at least one moveable blocking member configured to be electrically controllable, wherein the at least one blocking member is configured to selectively seal the at least one filter hole.

The transducer may comprise a membrane, wherein the at least one filter hole is located in the membrane.

The transducer may comprise a membrane support neighbouring and surrounding the membrane, wherein at least one filter hole is located in the membrane support.

The transducer may comprise a back plate configured to define a volume of air between the membrane and the back plate.

The transducer may be a capacitive transducer and the membrane and back plate are the two plates of the transducer.

The blocking member may comprise a resilient member biased in an open or blocking state.

The transducer may further comprise a blocking member actuator.

The blocking member actuator may comprise at least one bias member, wherein the at least one bias member is configured to be electrically or electrostatically charged to attract or repel the blocking member.

The blocking member may comprise: an anti-stick coating; and an anti-stick profile.

The transducer may comprise at least one of: a microphone; and a speaker.

An apparatus may comprise: the transducer as described herein; and a controller configured to control the mechanical acoustic filter.

The apparatus may further comprise a sensor configured to determine the activity of the acoustic transducer, wherein the controller is further configured to control the mechanical acoustic filter dependent on the sensor activity value.

The controller may be configured to control the mechanical acoustic filter in at least one of: a binary mode of control; a continuous mode of control and a discrete stepwise control.

According to a second aspect of the application there is provided a method for a micro-electromechanical system, MEMS, microphone transducer comprising a membrane (203) and a back plate (205) configured to define a volume of air therebetween, the method comprising: electrically controlling a mechanical acoustic filter to change the acoustic properties of the transducer, wherein the mechanical acoustic filter comprises at least one filter hole and electrically controlling said mechanical acoustic filter comprises electrically controlling a moveable blocking member within said volume of air to selectively seal the at least one filter hole.

The transducer may comprise a membrane, wherein the at least one filter hole is located in the membrane.

The method may comprise locating the at least one filter hole in a membrane support neighbouring and surrounding the membrane.

The transducer may comprise a back plate configured to define a volume of air between the membrane and the back plate.

The transducer may be a capacitive transducer and the membrane and back plate are the two plates of the transducer.

The blocking member may comprise a resilient member, and the method may further comprise biasing the blocking member in an open or blocking state.

The method may further comprise electrically or electrostatically charging at least one blocking member actuator to attract or repel the blocking member.

The method may further comprise: determining the activity of the transducer; and electrically controlling the mechanical acoustic filter to change the acoustic properties of the transducer comprises changing the acoustic properties dependent on the activity value of the transducer.

Electrically controlling the mechanical acoustic filter to change the acoustic properties of the transducer may comprise controlling the mechanical acoustic filter in at least one of: a binary mode of control; a continuous mode of control and a discrete stepwise control.

The embodiments and/or examples disclosed in the following description which are not covered by the appended claims are considered as not being part of the present invention.

### Summary of Figures

For better understanding of the present invention, reference will now be made by way of example to the accompanying drawings in which:
Figure 1 shows schematically an electronic device employing embodiments of the invention;
Figure 2a shows schematically the electronic device in further detail;
Figure 2b shows schematically some functional components of the electronic device according to some embodiments;
Figure 3 shows schematically an example topology for the transducer according to some embodiments;
Figure 4 shows schematically a further view of the example topology of the transducer according to some embodiments;
Figure 5 shows schematically a further example topology for the transducer according to some embodiments;
Figure 6 shows schematically the transducer in detail and the opening and closing of sound channels according to some embodiments;
Figure 7 shows a further topology for the transducer according to some embodiments;
Figure 8 shows a flow diagram showing the operation of the transducer; and
Figure 9 shows schematic example frequency response graphs for the transducer operating with the sound channel open and closed.

### Description of Example Embodiments

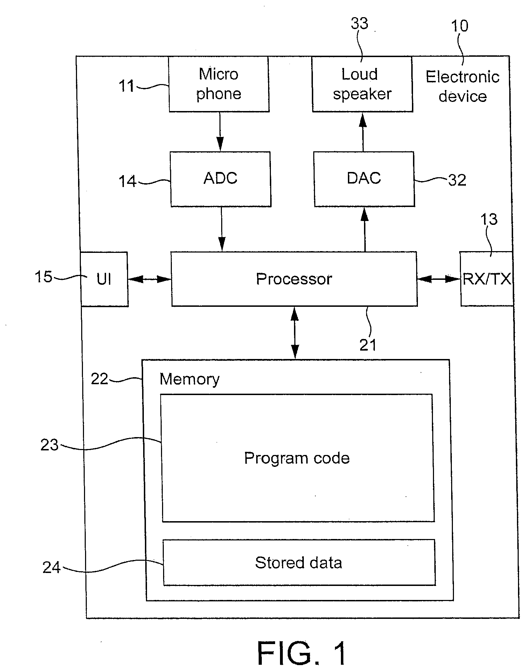

The following describes in further detail suitable apparatus and possible mechanisms for the provision of transducers having changeable acoustic properties. In this regard reference is first made to Figure 1 which shows a schematic block diagram of an exemplary apparatus or electronic device 10, which may incorporate transducers having changeable acoustic properties according to some embodiments. In the following examples and embodiments the transducer receives or generates an analogue signal which is processed by an associated analogue to digital converter, however it would be understood that in some embodiments the microphone/speaker is an integrated transducer generating digital or receiving digital signals directly. Furthermore in some embodiments the transducer mechanical filter is a pure analogue design, in other words processing is performed in the analogue domain with respect to the mechanical acoustic filter.

The electronic device 10 may for example be a mobile terminal or user equipment of a wireless communication system.

The electronic device 10 comprises a microphone 11, which is linked via an analogue-to-digital converter (ADC) 14 to a processor 21. The processor 21 is further linked via a digital-to-analogue (DAC) converter 32 to loudspeakers 33. The processor 21 is further linked to a transceiver (TX/RX) 13, to a user interface (UI) 15 and to a memory 22.

The processor 21 may be configured to execute various program codes. The implemented program codes may comprise encoding code routines. The implemented program codes 23 may further comprise an audio decoding code. The implemented program codes 23 may be stored for example in the memory 22 for retrieval by the processor 21 whenever needed. The memory 22 may further provide a section 24 for storing data.

The user interface 15 may enable a user to input commands to the electronic device 10, for example via a keypad, and/or to obtain information from the electronic device 10, for example via a display. The transceiver 13 enables a communication with other electronic devices, for example via a wireless communication network. The transceiver 13 may in some embodiments of the invention be configured to communicate to other electronic devices by a wired connection.

It is to be understood again that the structure of the electronic device 10 could be supplemented and varied in many ways.

A user of the electronic device 10 may use the microphone 11 for inputting speech, or other sound signal, that is to be transmitted to some other electronic device or that is to be stored in the data section 24 of the memory 22. A corresponding application has been activated to this end by the user via the user interface 15. This application, which may be run by the processor 21, causes the processor 21 to execute the encoding code stored in the memory 22.

The analogue-to-digital converter 14 may convert the input analogue audio signal into a digital audio signal and provides the digital audio signal to the processor 21.

The processor 21 may then process the digital audio signal in the same way as described with reference to the description hereafter.

The resulting bit stream is provided to the transceiver 13 for transmission to another electronic device. Alternatively, the coded data could be stored in the data section 24 of the memory 22, for instance for a later transmission or for a later presentation by the same electronic device 10.

The electronic device 10 may also receive a bit stream with correspondingly encoded data from another electronic device via the transceiver 13. In this case, the processor 21 may execute the decoding program code stored in the memory 22. The processor 21 may therefore decode the received data, and provide the decoded data to the digital-to-analogue converter 32. The digital-to-analogue converter 32 may convert the digital decoded data into analogue audio data and outputs the analogue signal to the loudspeakers 33. Execution of the decoding program code could be triggered as well by an application that has been called by the user via the user interface 15.

In some embodiments the loudspeakers 33 may be supplemented with or replaced by a headphone set which may communicate to the electronic device 10 or apparatus wirelessly, for example by a Bluetooth profile to communicate via the transceiver 13, or using a conventional wired connection.

In some embodiments the hardware integration of the transducers, such as the microphone 11 or the speaker 33, is in the form of a micro electromechanical system (MEMS) integrated circuit implementation. Although the description herein further details the operation of embodiments of the application with respect to microphone transducers it would be appreciated that the similar apparatus and methods can be employed to speaker operations and/or combined microphone speakers.

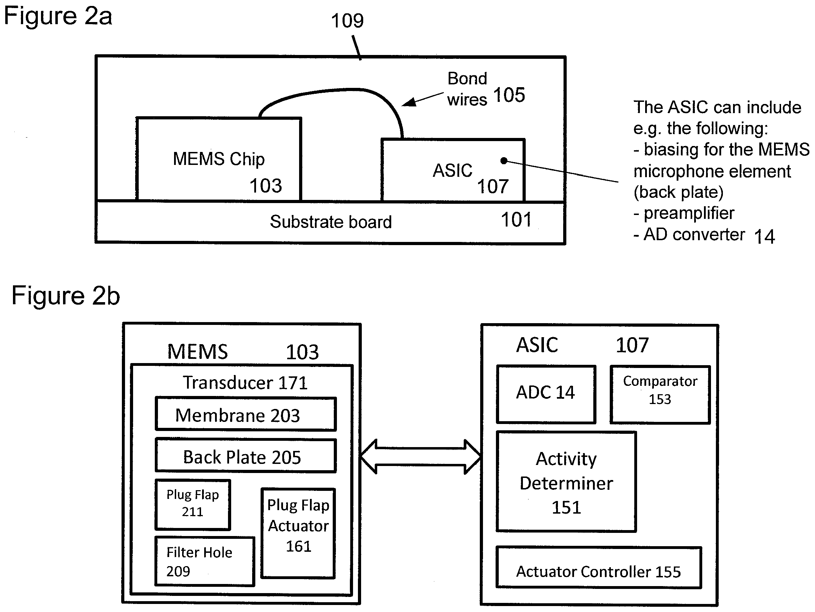

With respect to Figure 2a an example of the hardware integration of the transducer is shown within the electronic device or apparatus 10 according to some embodiments. In some embodiments the transducer and in particular the microphone 11 can be implemented as a micro-electromechanical system (MEMS) implemented on an integrated circuit or chip. Although the apparatus and methods described herein relate to a MEMS microphone transducer, any transducer employing a membrane (or surface, or diaphragm) for generating or detecting acoustic waves can implement similar embodiments. For example any suitable condenser microphone can employ a plug flap/filter hole combination as described herein.

The MEMS chip 103 can in some embodiments be mounted physically on the substrate board 101 within the casing 109 of the electronic device or apparatus 10. The MEMS chip 103 furthermore in some embodiments can be located neighbouring an acoustic portal provided within the casing of the electronic device or apparatus. The acoustic portal is configured to allow acoustic signals to pass 'through' the casing of the apparatus between the transducer and the environment the apparatus is operating in. In some embodiments the acoustic portal can be at least one hole in the casing. The hole can furthermore be covered in some embodiments by a dust or water resistant or proof screen to prevent foreign bodies from entering the device and damaging any components within the apparatus. The MEMS chip 103 can in some embodiments be mechanically and/or electrically fixed on the substrate 101 to prevent movement of the MEMS chip 103 and/or locate the MEMS chip 103 relative to the acoustic portal in the apparatus. In some embodiments the MEMS chip 103 can be mechanically located (mounted) on the substrate board 101 in such a manner that audio waves can pass through the acoustic portal (and in some embodiments sound channels between the casing and the MEMS chip 103) in the casing 109 to the MEMS chip 103. In some embodiments the substrate board 101 can itself comprise a sound channel through which the acoustic waves pass through.

With respect to Figure 2b, a schematic view of the MEMS chip 103 is shown.

In some embodiments the MEMS chip comprises a transducer 171, which is configured in the description herein to be to operate as the microphone 11. In some embodiments the MEMS chip 103 can comprise further transducers configured to operate as further microphones and/or configured to operate as a loudspeaker 33. However for clarity the following description describes embodiments of the application having a single transducer/single microphone implementation.

In some embodiments the transducer 171 comprises a membrane 203, a back plate 205, a blocking member 211, a filter hole 209, and a blocking member actuator 161.

The membrane 203 can be formed from any suitable material and is configured to move in response to acoustic signals or waves applying a force against the membrane. In some embodiments the membrane can be configured to be mechanically coupled to an actuator such as a moving magnet or moving coil to generate an electrical signal in response to the movement of the membrane. In some other embodiments the membrane is itself electrostatically or electrically charged and causes a change in potential as it moves. For example in some embodiments the membrane 203 is configured to be a mobile capacitor plate relative to a fixed capacitor plate provided by the back plate 205, electrical couplings to each of the two capacitor plates when charged will produce a varying potential as the membrane moves relative to the back plate.

The filter hole 209 can in some embodiments be implemented in the membrane 203. In other words, in some embodiments the membrane 203 is manufactured as being incomplete or with a portion of the membrane missing to form the filter hole 209. In some other embodiments the filter hole 209 can be implemented as a hole or missing or removed portion of the supporting structure which is also impinged by the acoustic waves or signals.

The blocking member, which can also be known as a sealing member, plug or plug flap 211 is configured to be actuated in such a way to permit the opening and closing of the filter hole 209. Thus in some embodiments the action of the blocking member and the filter hole form a mechanical acoustic filter (or electrically controllable mechanical acoustic filter means for changing the acoustic properties of a transducer) which can be activated when the blocking member 211 opens the filter hole 209 or be deactivated when the blocking member closes or seals the filter hole 209.

The back plate 205 is a material layer which can in some embodiments underlie the microphone membrane 203 and defines between a 'back volume' or acoustic chamber between the membrane 203 and the back plate 205. The relative position and form of the back plate 205 can in some embodiments be designed as a compromise between producing a good noise performance and overall size of the transducer as it would be understood that a smaller back volume is preferable to produce a smaller MEMS chip or transducer but producing a less acceptable noise spectrum of the noise floor output by the transducer. In some embodiments the back plate 205 comprises at least one back plate hole. The back plate hole can in some embodiments be further used to tune the response of the transducer and permit the membrane to move more freely. In some other embodiments the back plate hole can be located or formed in any support structure which also forms or defines the acoustic chamber. In some embodiments the back plate hole can be covered or at least partially covered to prevent or reduce foreign bodies entering the acoustic chamber.

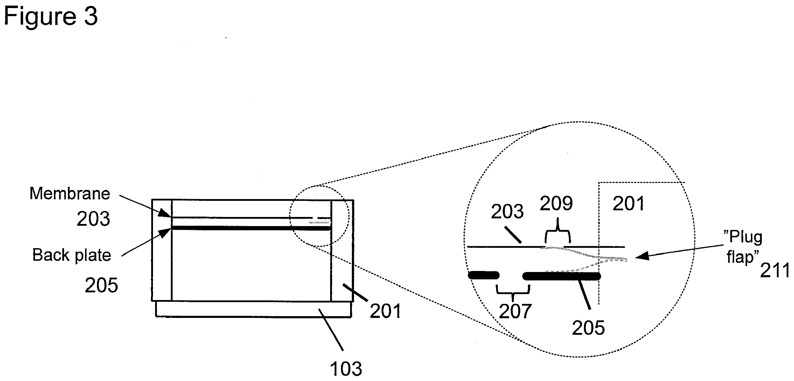

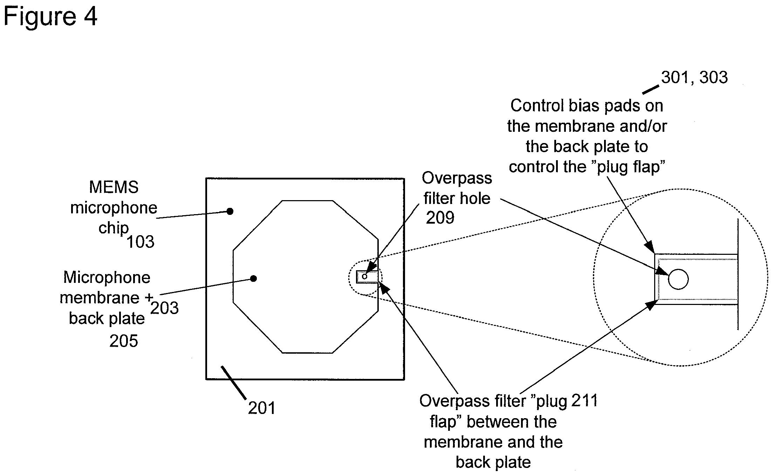

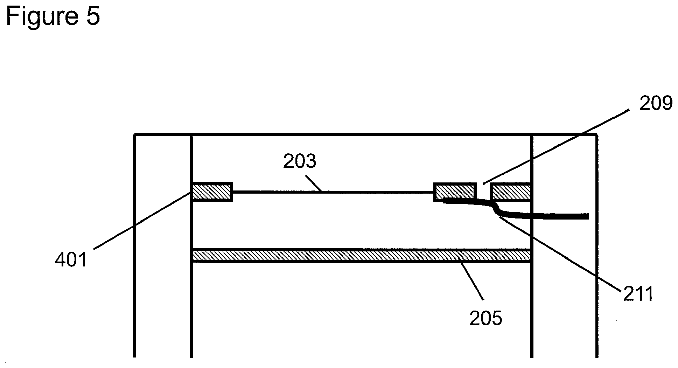

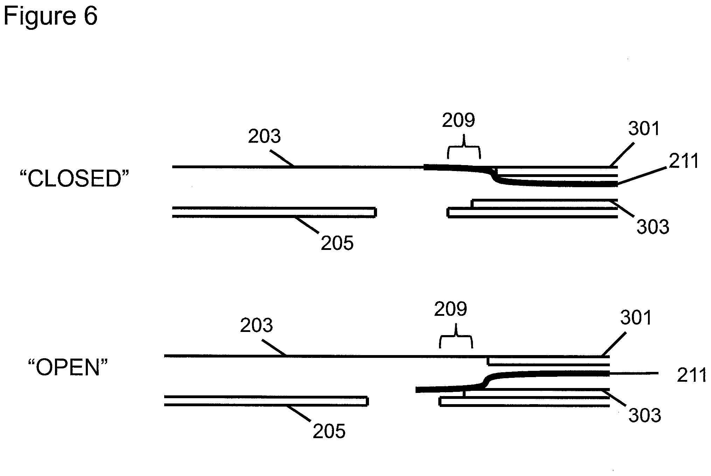

The topology of the transducer 171 can be further described in further detail with respect to Figures 3 and 4 which show a first example of the filter hole and blocking member forming the mechanical acoustic filter according to some embodiments, Figure 5 which shows a further example of the filter hole and blocking member arrangement forming a mechanical acoustic filter and Figure 6 which shows the operation of the filter hole and blocking member in further detail.

With respect to Figures 3 and 4, an example topology of a suitable micro-electromechanical system (MEMS) microphone structure for implementation in some embodiments of the application is shown in elevation and plan view. The MEMS 103 microphone comprises in some embodiments a support frame 201 configured to support elements of the microphone such as the membrane 203 and the back plate 205. The support frame 201 can in some embodiments for example be part of the external structure of the MEMS chip 103 into or through which a cavity can be machined for implementing the membrane/back plate. The support frame 201 in some embodiments. In the example shown in Figures 3 and 4 the support structure is octagonal, but could be circular or can be any suitable shaped structure. Within the support frame 201 of the MEMS chip 103 the microphone membrane 203 can be fixed at its edge and located such that at least a portion of the membrane can move in response to acoustic wave pressure. Also within the support frame 201 of the MEMS chip 103 the back plate 205 can be fixed at the back plate edge and located 'underneath' the membrane, where underneath specifies the direction opposite the impact of the acoustic waves on the membrane 203. Furthermore the relative location of the microphone membrane 203 and back plate 205 define a 'back volume' or acoustic chamber. The back volume/acoustic chamber can, as described herein, be designed such that the microphone is configured to produce a suitable frequency response.

Although the 'back plate' and back volume as shown in Figure 3 are orientated below the membrane as the acoustic waves act on the membrane from the upper surface, it would be understood that the orientation of the membrane and the relative positions of the back plate and therefore the back volume can be any suitable direction.

Furthermore as shown in Figures 3 and 4, the membrane 203 has located within itself the filter hole 209, located near to the edge of the membrane and creating a potential through hole in the membrane linking the back volume to the front volume of the MEMS microphone device. In the example shown in Figure 1 the filter hole 209 is a circular hole in the membrane however it would be understood that any suitable shape of dimension of hole can be implemented. Furthermore in the examples shown in Figures 3 and 4 there is only one filter hole which forms the mechanical acoustic filter however more than a single hole can be implemented.

Furthermore the blocking member 211 can as shown in Figures 3 and 4 be configured such that at least a portion of the blocking member 211, the fixed end, is located or fixed with respect to the support frame 201 and a further portion, a movable end, is able to move relative to the fixed end and be configured to be located in one of at least two positions. A first position for the moveable portion of the blocking member 211 is the blocking member 211 configured to be against the membrane 203 and to form a seal over the filter hole 209 and thus configured to close or block the filter hole 209 as can be seen in Figure 3 by the solid line representation of the blocking member 211. The second position for the moveable portion of the blocking member 211 is the blocking member 211 configured to be away from the membrane 203 and therefore does not form a seal over the filter hole 209 and thus opening the filter hole 209 as can be seen in Figure 3 by the dotted representation of the blocking member 211.

As can be seen in the example shown in Figure 4 the blocking member 211 located between the membrane and the back plate is a rectangular strip of material larger than the filter hole and flexible enough such that the moveable portion can move to form the seal over the filter hole 209 (closing the filter hole 209) and also move away from the filter hole 209 opening the filter hole 209.

Furthermore with respect to Figure 4, the MEMS microphone shows a blocking member actuator. The blocking member actuator in some embodiments can be a pair of control bias pads 301, 303. In such embodiments a first pad 301 can be located on the underside of the microphone membrane 203 and a second pad located on the upperside of the back plate 205. However it would be understood that in some embodiments at least one of the control bias pads may be located on the opposite sides of the membrane 203 or back plate 205 as the blocking member 211. The control bias pads 301, 303 can in some embodiments be activated to attract (or in some embodiments repulse) the blocking member 211. In some embodiments this can be implemented by the blocking member having a first electrostatic or electrical charge and then charging at least one of the control bias pads with a similar or opposite charge thus respectively repelling or attracting the movable portion of the blocking member 211.
In some embodiments the back plate 205 can further comprise a back plate hole 207. The back plate hole 207 is representative of at least one back plate hole attempting to minimise the noise contribution caused by acoustic resistance that effects the air moving between the back plate 205 and the membrane 203. In other words the air "pumped" by the membrane has an open path to the back volume because of the back plate holes. Thus the holes are configured such that any over or under pressure within the back volume between the membrane 203 and back plate 205 can be equalised via the hole with the volume behind the back plate 205. In some embodiments the back plate hole 207 can be more than a single hole and be any suitable shape. The location of the back plate hole 207 in the back plate forming a through hole between the back volume between the membrane and back plate and a volume behind the back plate 205 can be in any suitable location. In the example shown in Figure 3 the representative back plate hole 207 is located close but not directly underneath the filter hole 209.

In some embodiments, for example in optical sensing microphones, as described herein there can be optionally no back plate and as such the acoustic resistance is caused by the MEMS structure and the acoustic membrane pliability.

With respect to Figure 5, a further example topology for the MEMS microphone is shown. In this example topology the membrane 203 is smaller than the MEMS microphone support frame 201 and the membrane is directly supported by the membrane support structure 401 which in turn is fixed to the MEMS microphone support structure. In such embodiments and as shown in Figure 5 the filter hole 209 can be located within the membrane support structure 401 rather or as well as filter holes located in the membrane.

In such embodiments the blocking member 211 can be configured to operate to form a seal sealing the filter hole 209 when the blocking member 211 is activated to do so, and to open the filter hole 209 located in the membrane support structure 401 when not activated. The use of control bias pads 161 can in such embodiments be used whereby in some embodiments at least one pad can be located on the underside of the membrane support structure 401. It would also be understood that any of the other arrangement of actuators discussed herein could also be implemented in such embodiments as shown with respect to the example shown in Figure 5.

With respect to Figure 6 the operation of the mechanical acoustic filter in the transducer according to the examples discussed herein is shown in further detail. As can be seen in the first or 'closed' mode, the membrane 203 with filter hole 209, is located over and in contact with a first control bias pad 301, the back plate 205 is located under and in contact with a second control bias pad 303, and the membrane 203 and the back plate 205 define a back volume or acoustic chamber within which is located the blocking member 211. Furthermore in the first of 'closed' mode the blocking member 211 is configured to be attracted by the first bias pad 301 located on the underside of the membrane 203 attracting the moveable portion of the blocking member 211 to the underside of the membrane 203 and sealing the filter hole 209.

Figure 6 also shows the operation of the mechanical acoustic filter in the transducer in a second or 'open' mode, where the second bias plate 303 located on the upper side of the back plate 205 is biased (for example by using the opposite electrostatic or electrical charge to the charge stored in the blocking member 211) attracting the moveable portion of the blocking member away from the filter hole and opening the filter hole.

The above operations shown the actuation of the blocking member by a pull or attractive force, however it would be understood that in some embodiments the actuation of the plug flap could be actuated by the use of a push or repulsive force for example by charging at least one of the bias control pads with the same charge as in the moveable portion of the blocking member. Furthermore in some embodiments the actuation of the blocking member can be performed by a combination pull and push forces.

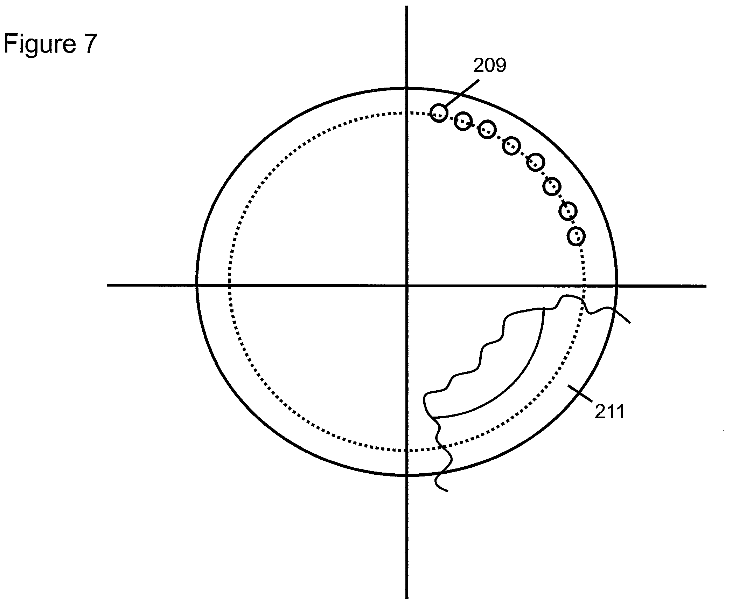

With respect to Figure 7 an example of multiple filter hole topology is shown whereby the microphone membrane 203 has located at a radius a plurality of filter holes 209. Underneath the membrane 203 as shown by the cut away section of Figure 7 is the blocking member 211 which in this embodiment sample is shown as a continuous strip of material suitable for forming a seal over all of the filter holes or for leaving all of the filter holes in an open state.

In such embodiments the dimension, positioning and the number of filter holes can be designed such that the frequency response of the transducer changes according to a desired amount when the filter holes are operated in the open mode compared to when the filter holes are operated in the closed mode.

Furthermore in some embodiments there can be multiple blocking members which can be independently controlled to close (or open) at least one filter hole each such that the frequency response of the microphone can be selectively tuned.

With respect to Figures 2a and 2b are shown apparatus for controlling the operation of the mechanical acoustic filter within the transducer. For example the apparatus shown in Figure 2a comprises an application specific integrated circuit (ASIC) 107 located on the substrate board 101 with the MEMS chip 103 and coupled to the MEMS chip 103 by a bond wire 105. The ASIC 107 can in some embodiments be optional with the functionality of the ASIC 107 implemented by other elements such as for example a processor running programs to perform the same functionality, the programs being stored on a memory which can also be used to store data to be processed or processed. In some embodiments the ASIC 107 or at least some elements of the ASIC 107 as described herein can be implemented within the MEMS chip 103. For example in some embodiments the analogue-to-digital converter 14 can be implemented within the MEMS chip 103.

With respect to Figure 2b the application specific integrated circuit (ASIC) 107 according to some embodiments of the application is shown in further detail. In such embodiments the ASIC 107 can comprise an analogue-to-digital converter (ADC) 14 which is configured to receive from the microphone (or transducer 171 operating as the microphone) and convert analogue electrical signals into a suitable digital format. In some embodiments the ASIC 107 can further comprise an equaliser. The equaliser can be configured with differing filter settings dependent on the activity of the blocking member and filter hole to assist tune the response of the membrane.

In some embodiments the ASIC 107 can comprise an activity determiner 151. The power determiner in some embodiments can be configured to receive the digital format signals from the ADC 14 and generate a measure of the microphone activity such as for example the power of the signal. In some other embodiments the activity measurement can be a frequency dependent power spectrum for the microphone signal over a determined window or time period. In such embodiments the ASIC 107 can comprise a time to frequency domain converter such as a fast fourier transform converter or discrete fourier transform converter or any suitable time to frequency domain converter. In some embodiment the ASIC 107 can comprise a filterbank prior to the activity determiner 151 and configured to determine the activity of the microphone output for frequency ranges.

In some embodiments the ASIC 107 can comprise a comparator 153 configured to compare the output of the activity determiner 151 against at least one determined threshold value. The comparator 153 can in some embodiments be a fixed one or be a dynamic comparator configured to be able to vary the threshold values dependent the condition of the MEMS microphone. For example in some embodiments the comparator 153 could vary the threshold values dependent on the age of the microphone, whether the microphone has been damaged or for any suitable reason.

In some embodiments the ASIC 107 can comprise an actuator controller 155. The actuator controller 155 can in some embodiments receive the output of the comparator 153 and generate a signal to power the blocking member actuator 161 within the MEMS microphone 103.

The ASIC 107 can in some embodiments comprise further elements of known microphone or audio processing systems such as a processing capability for biasing the MEMS microphone element (in other words generating the charge difference between the membrane and back plate) or a preamplifier (for receiving the analogue audio signal and amplifying the analogue audio signal so that the signal is output a suitable potential range).

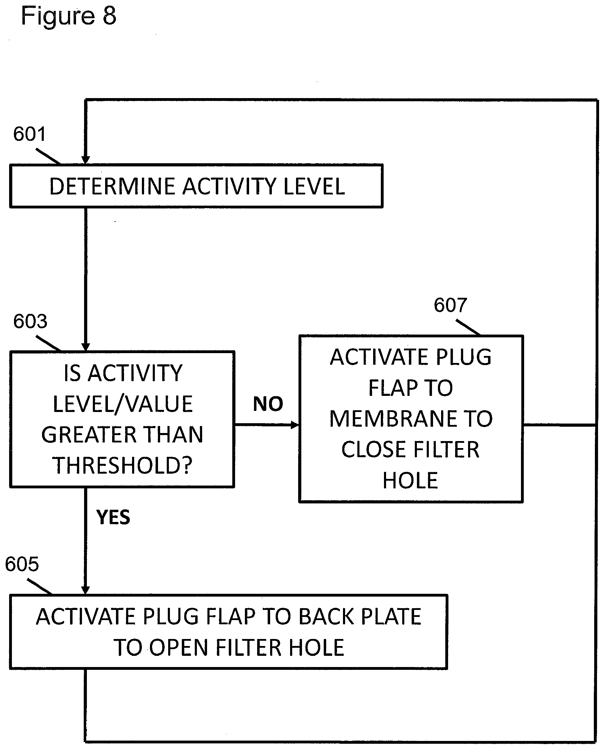

With respect to Figure 8, an example control mechanism and method is shown for controlling the plug flap and filter hole in an wind noise reduction application for the mechanical acoustic filter in the transducer.

As described herein the MEMS 103 microphone generates, for example in some embodiments by the motion of the membrane relative to the back plate a varying potential dependent on the acoustic waves applying a force to the membrane 203. The ASIC 107 analogue-to-digital converter 14 can in some embodiments generate a digital representation of the microphone output. Furthermore the activity determiner 151 can in some embodiments generate a representation of the microphone activity. This in some embodiments can comprise the activity determiner 151 being configured to determine the power level for the microphone output by squaring the output values from the ADC 14. However the activity level can in some embodiments be frequency range dependent, in other words a value representing each frequency bin or range.

The determination of the activity value is shown in Figure 8 by step 601.

In some embodiments the activity level can be passed to a comparator 153. The comparator 153 can in some embodiments compare this activity level or value against at least one determined threshold value. The at least one threshold value can be stored in the ASIC 107 or in a memory. In some embodiments the threshold value can be modified when the transducer is in use, in other words the comparator 153 can "learn" when the transducer is about to saturate or produce a activity level or value indicative of a microphone saturation.

The comparator 153 can output the results of the comparison to the actuator controller 155.

The operation of determining whether the saturation volume level is greater than a threshold value is shown in Figure 8 by step 603.

The actuator controller 155 can then be configured to receive the result from the comparator 153 and output a suitable signal to control the plug flap 211 using the blocking member actuator 161.

The actuator controller 155 can in some embodiments when the comparator 153 determines that the activity level is less than or equal to the determined threshold value send a signal to the blocking member actuator 161 to move the blocking member 211 to close the filter hole. For example in some embodiments the actuator controller 155 can be configured to pass a voltage level to the blocking member actuator 161 bias plates such that the first bias pad 301 (located on the underside of the membrane) is charged with a charge opposite to that of the blocking member to attract the blocking member to the membrane surface and seal the filter hole 209.

The controlling of the actuator to move the blocking member to the membrane to close the filter hole is shown in Figure 8 by step 607. Following this control operation the method can in some embodiments pass back to the determination of the activity levels.

The actuator controller 155 can in these embodiments be also configured to when the comparator determines the activity level is greater than the threshold value send a signal to the blocking member actuator 161 to move the blocking member to open the filter hole. For example in some embodiments the actuator controller 155 can be configured to pass a voltage level to the blocking member actuator second bias pad 303 (located on the back plate) with a charge opposite to the charge in the blocking member 211 to attract the blocking member away from the surface of the membrane 203 and opening the filter hole 209.

The controlling of the actuator to move the blocking member away from the membrane to open the filter hole is shown in Figure 8 by step 605.

Furthermore as described herein, this operation may be continuous and thus following the control operation the method passes back to a further determination of the activity of the microphone as shown in Figure 8 by step 601.

In some embodiments the actuation and deactivation of the blocking member can be controlled or delayed. Thus in such embodiments an attract and/or release time can be implemented such that the actuation from open to sealed hole is controlled by the determined attract time period and the deactivation from sealed to open filter hole is controlled by the determined release time period. These attract and/or release time periods can be chosen in some embodiments to achieve a pleasant sounding transient period.

In some embodiments the blocking member can be configured to be naturally biased in either the filter hole closed or filter hole open modes. For example in some embodiments the blocking member can be naturally biased, for example by use of a resilient or elastic member to seal the filter hole and to be attracted to the back plate when the back plate bias pad is activated. Similarly the blocking member can be naturally biased or located away from the filter hole and be actively biased to seal the filter hole. In some embodiments the actuation can be implemented by means other than a biased pad. For example in some embodiments the microphone membrane can be used as an actuator. In such embodiments the charge of the membrane itself can be sufficient to attract the blocking member. In some embodiments the membrane, back plate, or blocking member itself may be configured such to prevent a permanent latch up, in other words the blocking member is not attached to the membrane such that the actuator cannot open the filter hole. This can be achieved for example by having a membrane surface and/or blocking member surface which has a rough profile and therefore does not allow the blocking member to 'stick' to the membrane.

Furthermore in some embodiments permanent sticking or latch up of blocking members can be achieved by using an anti-stick coating on the blocking member and/or membrane.

In some embodiments where there are multiple filter holes, the filter holes can be implemented as different sizes or shapes and be individually controlled. For example in some embodiments filter holes can be opened and closed in such a manner that a gradual filter response change can be implemented.

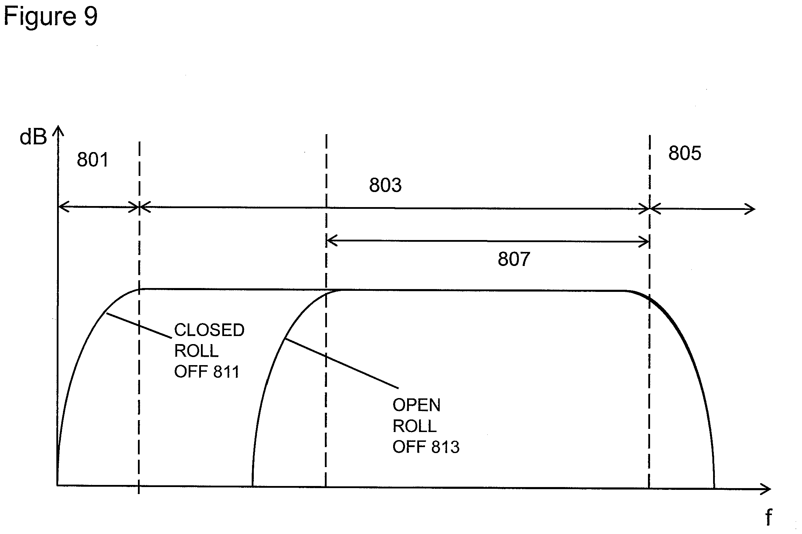

As shown in Figure 9 the operation of the mechanical acoustic filter (the opening and closing of the filter hole) is shown by the frequency response 811 of the transducer when the filter hole is closed. In this example the microphone has a low frequency roll off region 801 below which the microphone does not efficiently detect acoustic waves, a central frequency region 803 which defines a relatively frequency independent response section for the microphone, and a high frequency roll off region 805 which defines an upper roll off frequency region. Furthermore as also shown in Figure 9 is the frequency response 813 of the transducer when the filter hole is open. By opening the filter hole or operating the transducer in an open hole region the low frequency roll-off region occurs at a higher frequency, and therefore the open central frequency region 807 is smaller than when the filter hole is operated in a closed mode. Where the noise is 'white' or approximates to white noise the amount of noise detected by the microphone is therefore reduced, furthermore where the noise is low frequency specific the tuning of the filter hole mechanical acoustic filter can thus significantly reduce the noise detected whilst removing only a portion of the desired voice or other audio source energy.

It shall be appreciated that the term user equipment is intended to cover any suitable type of wireless user equipment, such as mobile telephones, portable data processing devices or portable web browsers. Furthermore, it will be understood that the term acoustic sound channels is intended to cover sound outlets, channels and cavities, and that such sound channels may be formed integrally with the transducer, or as part of the mechanical integration of the transducer with the device.

In general, the various embodiments of the invention may be implemented in hardware or special purpose circuits, software, logic or any combination thereof. For example, some aspects may be implemented in hardware, while other aspects may be implemented in firmware or software which may be executed by a controller, microprocessor or other computing device, although the invention is not limited thereto. While various aspects of the invention may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The embodiments of this invention may be implemented by computer software executable by a data processor of the mobile device, such as in the processor entity, or by hardware, or by a combination of software and hardware. Further in this regard it should be noted that any blocks of the logic flow as in the Figures may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, CD.

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs), application specific integrated circuits (ASIC), gate level circuits and processors based on multi-core processor architecture, as non-limiting examples.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre-stored design modules. Once the design for a semiconductor circuit has been completed, the resultant design, in a standardized electronic format (e.g., Opus, GDSII, or the like) may be transmitted to a semiconductor fabrication facility or "fab" for fabrication.

As used in this application, the term 'circuitry' refers to all of the following:
(a) hardware-only circuit implementations (such as implementations in only analog and/or digital circuitry) and
(b) to combinations of circuits and software (and/or firmware), such as: (i) to a combination of processor(s) or (ii) to portions of processor(s)/software (including digital signal processor(s)), software, and memory(ies) that work together to cause an apparatus, such as a mobile phone or server, to perform various functions and
(c) to circuits, such as a microprocessor(s) or a portion of a microprocessor(s), that require software or firmware for operation, even if the software or firmware is not physically present.

This definition of 'circuitry' applies to all uses of this term in this application, including any claims. As a further example, as used in this application, the term 'circuitry' would also cover an implementation of merely a processor (or multiple processors) or portion of a processor and its (or their) accompanying software and/or firmware. The term 'circuitry' would also cover, for example and if applicable to the particular claim element, a baseband integrated circuit or applications processor integrated circuit for a mobile phone or similar integrated circuit in server, a cellular network device, or other network device.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. An acoustic transducer (171) comprising:
a membrane (203) and a back plate (205) configured to define a volume of air therebetween; and
a mechanical acoustic filter configured to be electrically controllable to change the acoustic properties of the acoustic transducer (171), wherein the mechanical acoustic filter comprises at least one filter hole (209),
**characterized in that** the mechanical acoustic filter comprises, within said volume of air, at least one moveable blocking member (211) configured to be electrically controllable, wherein the at least one moveable blocking member (211) is configured to selectively seal the at least one filter hole (209).

2. The acoustic transducer (171) as claimed in claim 1, wherein the at least one filter hole (209) is located in the membrane (203).

3. The acoustic transducer (171) as claimed in claim 1 or 2, wherein the acoustic transducer (171) comprises a membrane support (401) surrounding the membrane (203) and the at least one filter hole (209) is located in the membrane support (401).

4. The acoustic transducer (171) as claimed in any of claims 1 to 3, wherein the acoustic transducer (171) is a capacitive transducer comprising the membrane (203) and the back plate (205).

5. The acoustic transducer (171) as claimed in any of claims 1 to 4, wherein the at least one moveable blocking member (211) comprises a resilient member biased in an open or blocking state.

6. The acoustic transducer (171) as claimed in any of claims 1 to 5, further comprising a blocking member actuator (161).

7. The acoustic transducer (171) as claimed in claim 6, wherein the blocking member actuator (161) comprises at least one bias member (301, 303), wherein the at least one bias member (301, 303) is configured to be electrically or electrostatically charged to attract or repel the moveable blocking member (211).

8. The acoustic transducer (171) as claimed in any of claims 1 to 6, wherein the moveable blocking member (211) comprises at least one of the following:
an anti-stick coating; and
an anti-stick profile.

9. An apparatus (10) comprising:
the acoustic transducer (171) as claimed in any of claims 1 to 8; and
a controller (155) configured to control the mechanical acoustic filter.

10. The apparatus (10) as claimed in claim 9, further comprising a sensor configured to determine the activity of the acoustic transducer (171), wherein the controller (155) is further configured to control the mechanical acoustic filter dependent on the sensor value.

11. A method for an acoustic transducer (171) comprising a membrane (203) and a back plate (205) configured to define a volume of air therebetween, the method comprising a step of:
electrically controlling (605, 607) a mechanical acoustic filter to change the acoustic properties of the acoustic transducer (171), wherein the mechanical acoustic filter comprises at least one filter hole (209),
**characterized in that** electrically controlling said mechanical acoustic filter comprises electrically controlling a moveable blocking member (211) within said volume of air to selectively seal the at least one filter hole (209).

## Patentansprüche

1. Akustischer Wandler (171), der Folgendes umfasst:
eine Membran (203) und eine Stützplatte (205), dazu ausgelegt, ein Volumen von Luft dazwischen zu definieren; und
einen mechanischen akustischen Filter, dazu ausgelegt, elektrisch steuerbar zu sein, um die akustischen Eigenschaften des akustischen Wandlers (171) zu ändern, wobei der mechanische akustische Filter mindestens ein Filterloch (209) umfasst,
**dadurch gekennzeichnet, dass** der mechanische akustische Filter, innerhalb des Volumens von Luft, zumindest ein bewegbares Blockierelement (211) umfasst, das dazu ausgelegt ist, elektrisch steuerbar zu sein, wobei das zumindest eine bewegbare Blockierelement (211) dazu ausgelegt ist, das mindestens eine Filterloch (209) gezielt abzudichten.

2. Akustischer Wandler (171) nach Anspruch 1, wobei sich das mindestens eine Filterloch (209) in der Membran (203) befindet.

3. Akustischer Wandler (171) nach Anspruch 1 oder 2, wobei der akustische Wandler (171) eine Membranstütze (401) umfasst, die die Membran (203) umgibt, und sich das mindestens eine Filterloch (209) in der Membranstütze (401) befindet.

4. Akustischer Wandler (171) nach einem der Ansprüche 1 bis 3, wobei der akustische Wandler (171) ein kapazitiver Wandler ist, der die Membran (203) und die Stützplatte (205) umfasst.

5. Akustischer Wandler (171) nach einem der Ansprüche 1 bis 4, wobei das zumindest eine bewegbare Blockierelement (211) ein elastisches Element umfasst, das in einem offenen oder blockierenden Zustand vorgespannt ist.

6. Akustischer Wandler (171) nach einem der Ansprüche 1 bis 5, ferner umfassend einen Aktuator (161) für das blockierende Element.

7. Akustischer Wandler (171) nach Anspruch 6, wobei der Aktuator (161) für das blockierende Element zumindest ein Vorspannungselement (301, 303) umfasst, wobei das zumindest eine Vorspannungselement (301, 303) dazu ausgelegt ist, elektrisch oder elektrostatisch geladen zu werden, um das bewegbare blockierende Element (211) anzuziehen oder abzustoßen.

8. Akustischer Wandler (171) nach einem der Ansprüche 1 bis 6, wobei das bewegbare Blockierelement (211) zumindest eines von Folgendem umfasst:
eine Antihaftbeschichtung; und
ein Antihaftprofil.

9. Einrichtung (10), die Folgendes umfasst:
den akustischen Wandler (171) nach einem der Ansprüche 1 bis 8; und
eine Steuerung (155), dazu ausgelegt, den mechanischen akustischen Filter zu steuern.

10. Einrichtung (10) nach Anspruch 9, ferner umfassend einen Sensor, der dazu ausgelegt ist, die Aktivität des akustischen Wandlers (171) zu bestimmen, wobei die Steuerung (155) ferner dazu ausgelegt ist, den mechanischen akustischen Filter abhängig von dem Sensorwert zu steuern.

11. Verfahren für einen akustischen Wandler (171), umfassend eine Membran (203) und eine Stützplatte (205), dazu ausgelegt, ein Volumen von Luft dazwischen zu definieren, wobei das Verfahren einen folgenden Schritt umfasst:
elektrisches Steuern (605, 607) eines mechanischen akustischen Filters zum Ändern der akustischen Eigenschaften des akustischen Wandlers (171), wobei der mechanische akustische Filter mindestens ein Filterloch (209) umfasst,
**dadurch gekennzeichnet, dass** elektrisches Steuern des mechanischen akustischen Filters elektrisches Steuern eines bewegbaren blockierenden Elements (211) innerhalb des Volumens von Luft umfasst, um das mindestens eine Filterloch (209) gezielt abzudichten.

## Revendications

1. Transducteur acoustique (171) comprenant :
une membrane (203) et une plaque arrière (205) configurées pour définir entre elles un volume d'air ; et
un filtre acoustique mécanique configuré pour être électriquement contrôlable pour modifier les propriétés acoustiques du transducteur acoustique (171), le filtre acoustique mécanique comprenant au moins un trou de filtre (209),
**caractérisé en ce que** le filtre acoustique mécanique comprend, à l'intérieur dudit volume d'air, au moins un élément de blocage mobile (211) configuré pour être électriquement contrôlable, l'au moins un élément de blocage mobile (211) étant configuré pour sceller sélectivement l'au moins un trou de filtre (209).

2. Transducteur acoustique (171) selon la revendication 1, dans lequel l'au moins un trou de filtre (209) est situé dans la membrane (203).

3. Transducteur acoustique (171) selon la revendication 1 ou 2, le transducteur acoustique (171) comprenant un support de membrane (401) entourant la membrane (203) et l'au moins un trou de filtre (209) étant situé dans le support de membrane (401).

4. Transducteur acoustique (171) selon l'une quelconque des revendications 1 à 3, le transducteur acoustique (171) étant un transducteur capacitif comprenant la membrane (203) et la plaque arrière (205).

5. Transducteur acoustique (171) selon l'une quelconque des revendications 1 à 4, dans lequel l'au moins un élément de blocage mobile (211) comprend un élément élastique polarisé dans un état ouvert ou de blocage.

6. Transducteur acoustique (171) selon l'une quelconque des revendications 1 à 5, comprenant en outre un actionneur d'élément de blocage (161).

7. Transducteur acoustique (171) selon la revendication 6, dans lequel l'actionneur d'élément de blocage (161) comprend au moins un élément de polarisation (301, 303), l'au moins un élément de polarisation (301, 303) étant configuré pour être chargé électriquement ou électrostatiquement pour attirer ou repousser l'élément de blocage mobile (211).

8. Transducteur acoustique (171) selon l'une quelconque des revendications 1 à 6, dans lequel l'élément de blocage mobile (211) comprend au moins un des éléments suivants :
un revêtement antiadhésif ; et
un profil antiadhésif.

9. Appareil (10) comprenant :
le transducteur acoustique (171) selon l'une quelconque des revendications 1 à 8 ; et
un contrôleur (155) configuré pour contrôler le filtre acoustique mécanique.

10. Appareil (10) selon la revendication 9, comprenant en outre un capteur configuré pour déterminer l'activité du transducteur acoustique (171), le contrôleur (155) étant en outre configuré pour contrôler le filtre acoustique mécanique en fonction de la valeur de capteur.

11. Procédé pour un transducteur acoustique (171) comprenant une membrane (203) et une plaque arrière (205) configurées pour définir entre elles un volume d'air, le procédé comprenant une étape de :
contrôle électrique (605, 607) d'un filtre acoustique mécanique pour modifier les propriétés acoustiques du transducteur acoustique (171), le filtre acoustique mécanique comprenant au moins un trou de filtre (209),
**caractérisé en ce que** le contrôle électrique dudit filtre acoustique mécanique comprend le contrôle électrique d'un élément de blocage mobile (211) à l'intérieur dudit volume d'air pour sceller sélectivement l'au moins un trou de filtre (209).
